Europäisches Patentamt

European Patent Office

Office européen des brevets

(11) Publication number: **0 360 596**
**A1**

# EUROPEAN PATENT APPLICATION

(21) Application number: **89309585.1**

(22) Date of filing: **20.09.89**

(51) Int. Cl.5: **H 01 L 27/118**

(30) Priority: **20.09.88 JP 235233/88**

(43) Date of publication of application:
**28.03.90 Bulletin 90/13**

(84) Designated Contracting States: **DE FR GB NL**

(71) Applicant: **Matsushita Electronics Corporation**
**1006, Oaza-Kadoma Kadoma-shi**
**Osaka 571 (JP)**

(72) Inventor: **Chimura, Moriyuki**
**9-8 6-chome Kita-kutsukake-cho**
**Ohe Nishikyo-ku Kyoto (JP)**

(74) Representative: **Dawson, Elizabeth Ann et al**
**A.A. THORNTON & CO. Northumberland House 303-306**
**High Holborn**
**London WC1V 7LE (GB)**

(54) **Semiconductor integrated circuit and manufacturing method thereof.**

(57) In this invention, a wafer having plural basic circuit elements formed in the entire surface portion thereof without leaving any space according to predetermined repetition patterns is used as a master slice. According to the invention, chips in an optimum size depending on the circuit scale of the final product may be produced, and the number of unused, wasteful basic circuit elements may be kept to a minimum. Besides, it is not necessary to prepare multiple types of master slices, and hence the production efficiency may be enhanced.

F I G. 2

## Description

### SEMICONDUCTOR INTEGRATED CIRCUIT AND MANUFACTURING METHOD THEREOF

This invention relates to a master slice type semi-conductor integrated circuit which a lot of basic circuit elements are formed in the entire surface portion of a wafer, and a manufacturing method thereof.

The developing period of electronic appliances is becoming shorter every year, and the developing period of the semiconductor integrated circuits incorporated in the electronic appliances is also becoming shorter. To meet such needs, recent attentions are drawn to a semiconductor integrated circuit of the so-called master slice type for realizing a final desired circuit by preparing a wafer having basic circuit elements formed in the surface portion of a wafer as a master slice, and connecting necessary basic circuit elements by one-layer or multi-layer wiring according to the requests of customers. As a typical example of master slice type semiconductor integrated circuit, the gate array is known.

As the most typical type of gate array, so-called "channel type" is known. In this type, cell regions forming basic circuit elements and wiring regions for forming wiring are separately disposed within a circuit forming area of one chip. However, in such "channel type" gate array, since the cell regions and wiring regions are separately disposed, the integration scale cannot be heightened.

More lately, therefore, the gate array of the type called "Sea of Gates (SOG)" is being noticed.

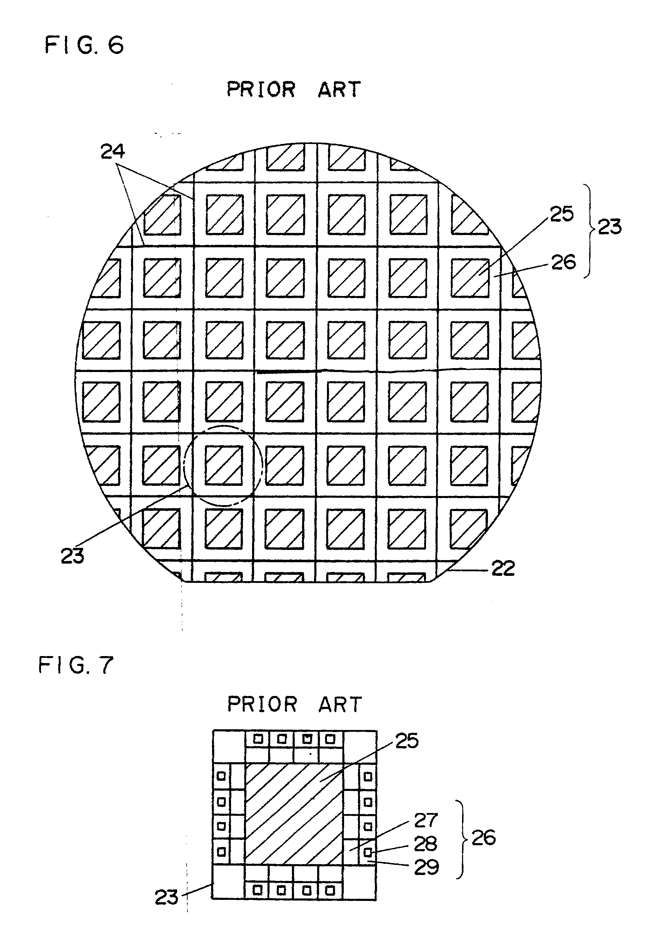

FIG. 6 shows a master slice of gate array of SOG type. In the master slice shown in FIG. 6, multiple chips 23 are formed in the neatly entire surface portion of the wafer 22. Among these chips, scribe lanes 24 for dividing the wafer 22 into individual chips 23 are formed. Within each chip 23 enclosed with scribe lanes 24, a basic circuit element region 25 forming basic circuit elements and its peripheral region 26 are disposed.

Fig. 7 is an enlarged plan view of one chip 23 shown in FIG. 6. In FIG. 7, in the basic circuit element region 25, transistor elements which are basic elements of the gate array are formed without space in the entire surface portion of the basic circuit element region 25. In other words, unlike "chanel type" gate array mentioned above, cell regions forming basic circuit elements and wiring regions are not disposed separately in the chip, but only cell regions are disposed almost in the whole area of the middle of the chip. Thus, it looks as that the entire principal area of the chip were covered with transistor elements (gates) like the sea, and hence the gate array of this type was named "Sea of Gates." Moreover, as shown in Fig. 7, a peripheral region 26 is formed around the basic circuit element region 25. This peripheral region 26 contains an input/output circuit element region for forming input/output circuits and a pad region 29 for forming a bonding pad 28.

In other words, the gate array of the conventional SOG type shown in FIGS. 6, 7 is composed of fixed size of basic circuit element region 25 and fixed size of peripheral region 26 disposed around the basic circuit element region 25, and therefore, the total chip size is also fixed depending on the required circuit scale.

Actually, since the circuit scale varies depending on the needs of the customers, it is necessary to prepare several to tens of types of master slice differing in the circuit scale and select the most suited one from these master slices depending on a desired semiconductor integrated circuit scale

However, in the conventional gate array as shown in FIG. 6, 7, the master slice exactly matching with the desired circuit scale may not be always prepared. Therefore, in actual manufacturing processes, it is inevitable to select a master slice of the circuit size most approximate to the desired circuit scale and fabricate a semiconductor integrated circuit using the selected master slice. In this case, a considerable portion of unnecessary region not actually contributing to the circuit formation is produced.

For example, if the circuit scale of the final desired product is 10,000 gates, considering the gate availability, it is impossible to produce the final product of 10,000 gates by using a master slice of 10,000 gates. Actually, therefore, the final product of 10,000 gates is fabricated by using a master slice of 15,000 or 20,000 gates, and in this case 5,000 to 10,000 gates are wasteful.

To minimize such waste, it is necessary to prepare many tyeps of master slice differing in the circuit scale so as to cope with various circuit scales of the final products. It, however, requires an enormous labor in preparation of master slices. Besides, many master slices that may not be possibly used must be always kept in stock. As a result, the total manufacturing cost is not substantially reduced.

It is hence a first object of the invention to present a semiconductor integrated circuit and a manufacturing method thereof capable of forming a chip of desired size depending on the circuit scale of the final product on one kind of master slice.

It is a second object of the invention to present a semiconductor integrated circuit capabel of realizing an exact driving capability depending on the circuit specification of the final product.

This invention, in sum, is designed to form plural basic circuit elements in the entire surface portion of a single wafer, without leaving any space according to specified repetition patterns.

In this way, the size of an internal circuit region, an input/output circuit region and a pad region can be set an optimum size suited to the circuit scale of the final product. As a result, the number of unused basic circuit elements can be kept to a minimum. Besides, it is not necessary to prepare many types of wafers differing in the number of basic circuit elements as master slice, the total production cost may be notably reduced.

Other objects of the invention, along with the features and advantages thereof, will be better understood and appreciated in the following detailed description of the preferred embodiments taken in conjunction with the drawings.

FIG. 1 is a plan view showing a master slice of a semiconductor integrated circuit in a first embodiment of the invention;

FIG. 2 is an enlarged plan view of one chip of the master slice shown in FIG. 1;

FIG. 3 is a plan view showing the repetition pattern of basic circuit elements in the basic circuit element region in a second embodiment of the invention;

FIG. 4 is an equivalent circuit diagram of the repetition pattern in FIG. 3;

FIG. 5 is a sectional view of peripheral portion of the same embodiment;

FIG. 6 is a plan view showing the master slice of a conventional semiconductor integrated circuit; and

FIG. 7 is an enlarged plan view of one chip of the master slice shown in FIG. 6.

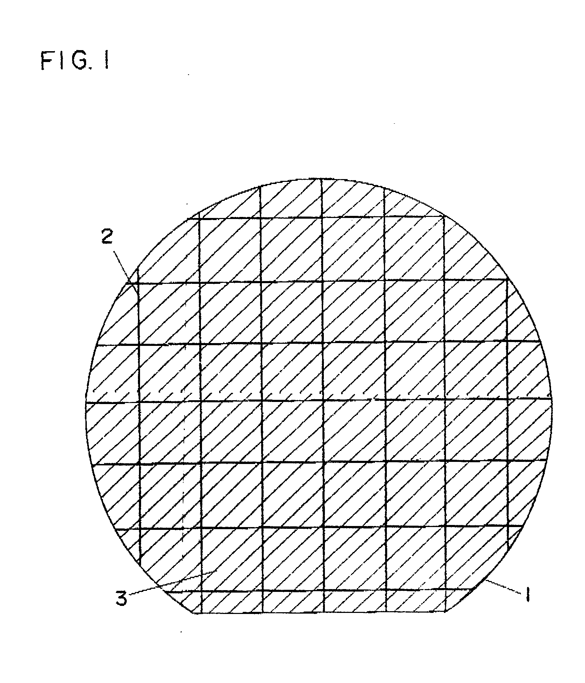

FIG. 1 is a plan view of a semiconductor integrated circuit in an embodiment of the invention.

In the master slice shown in FIG. 1, plural basic circuit elements are formed without leaving any space in the whole surface portion of a wafer 1 according to specified repetition pattern. At positions suited to the circuit scale of the desired final product, scribe lanes 2 are set and an area enclosed by these scribe lanes 2 is defined as one chip 3. Besides, an insulation film (not shown) is formed on the entire surface of the wafer 1.

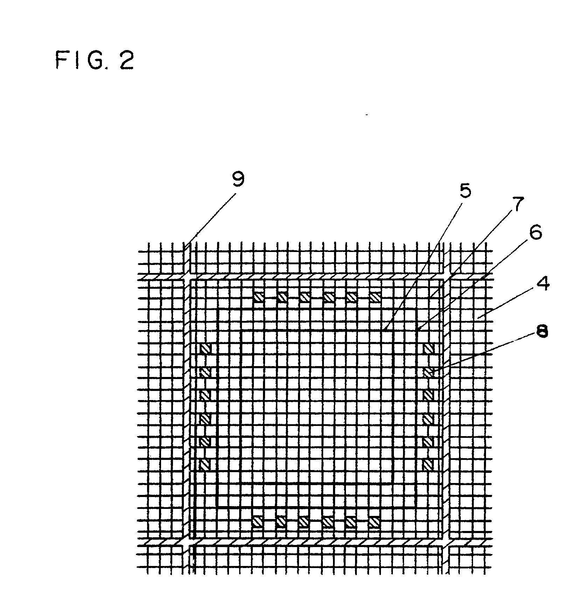

FIG. 2 is an enlarged plan view of one chip of the master slice in FIG. 1. In FIG. 2, basic circuit elements 4 are neatly arranged in the vertical and lateral directions, regardless of inside or outside the region of one chip portion, in the entire surface portion of the wafer 1 shown in FIG. 1. In the example shown in FIG. 2, the central region composed of 13 × 13 basic circuit elements 4 is regarded as an internal circuit region 5, and by mutually connecting the basic circuit elements 4 in this internal circuit region 5 by wirings (not shown) formed on the insulation film and through-holes formed in the insulation film, a desired circuit is composed. The area consisting of two rows of basic circuit elements 4 surrounding the periphery of the internal circuit region 5 is an input/output circuit region 6, and by mutually connecting the basic circuit elements 4 within this region 6 by wirings (not shown), necessary input circuits or output circuits are composed. The area consisting of nearly 2.5 rows of basic circuit elements 4 surrounding the periphery of the input/output circuit region 6 is a pad region 7. A required number of pads 8 are formed in the pad region 7. More specifically, pads 8 are formed by forming metal layer such as aluminum layer in a required pattern on the insulation film in the pad region 7. Meanwhile, the basic circuit elements 4 in the internal circuit region 5 and input/output circuit region 6, and the pads 8 in the pad region 7 are mutually connected by wirings (not shown), and the circuit connections of one chip protion are all completed, and the desired final circuit is realized.

On the outer circumference of the pad region 7, scribe lanes 9 are disposed. The scribe lanes 9 may be also virtual, or, instead, protective films or the like formed on the insulation film for preventing crack or breakage of the substrate when dividing the wafer 1.

The above is the composition of the master slice of the semiconductor integrated circuit in one embodiment of the invention.

A method of manufacutring a semiconductor integrated circuit using such master slice is explained below.

In the first place, a master slice as shown in FIG. 1 is prepared.

Next, an internal circuit region 5 is in a size suited to the circuit scale of the desired final product is defined. Furthermore, an input/output circuit region 6 and a pad region 7 are defined in a size neither excessive nor insufficient for realizing the input/output function of the final product. Moreover, on the outer circumference of the pad region 7, scribe lanes 9 for dividing wafer are defined. According to the circuit specification of the final product, wirings made of aluminum or the like are formed in a specified pattern on the insulation film and in necessary through-holes so as to mutually connect the electrodes of the basic circuit elements 4 in the internal circuit region 5 and input/output circuit region 6. In this wiring process, meanwhile, necessary pads 8 are formed in the pad region 7 at the same time. As a result of this wiring process, all connections of basic circuit elements 4 and pads 8 necessary for one chip are completed, and the desired final circuit is realized.

Afterwards, a protective film such as passivation film is formed on the surface of the wafer 1, and the wafer 1 is cut off along the scribe lanes 9 by means of dicing saw or the like to be divided into individual chips.

Then, through assembly process, inspection process and others, a final semiconductor integrated circuit is completed.

Thus, according to the embodiment shown in FIGS. 1, 2, by preparing the wafer 1 in which predetermined repetition patterns of the basic circuit elements 4 are formed in the entire surface portion without leaving any space as a master slice, and defining the internal circuit region 5, input/output circuit region 6, and pad region 7 in an optimum size depending on the circuit scale of the final product, a desired circuit may be realized in these regions. Accordingly, occurrence of wasteful regions as experienced in the conventional gate array may be kept to a minimum. Still more, it is enough to prepare only one type of master slice for final products of various circuit scales, and the preparations of the master slice itself is very easy. Moreover, it is not required to keep multiple unused master slices in stock, the total manufacutirng cost may be significantly curtailed.

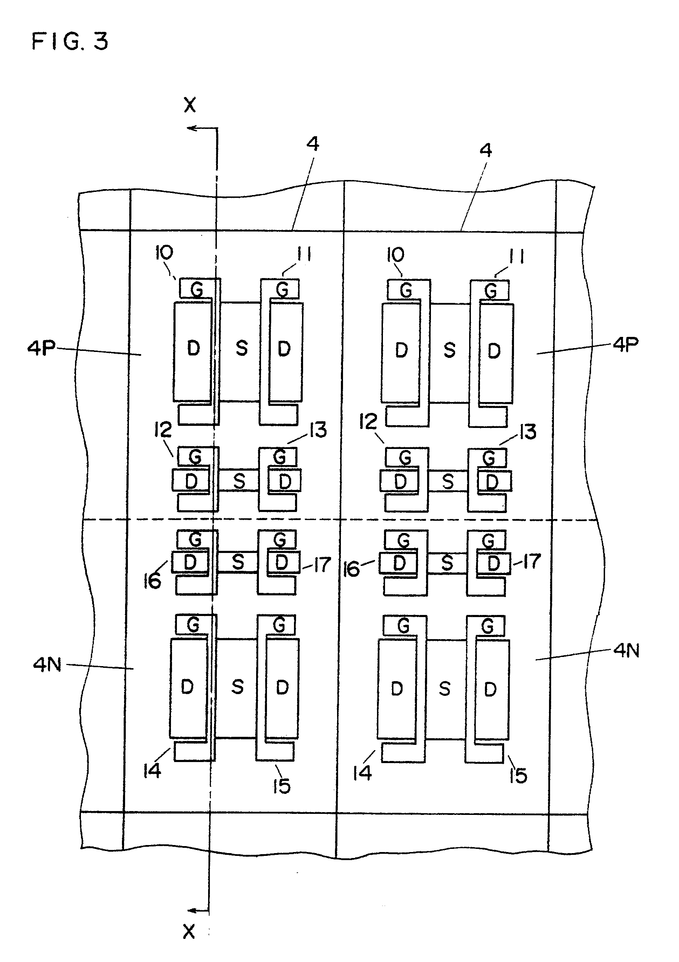

FIG. 3 shows a practical structure of basic circuit elements 4 in a second embodiment of the invention. In FIG. 3, CMOS transistor elements are shown.

In FIG. 3, in P-channel regions 4P are formed first and second P-channel transistors 10, 11, and third and fourth P-channel transistors 12, 13. Each one of the transistors 10 to 13 is composed of a gate region G. a drain region D, and a common source region S. The length of the gate G of the first and second P-channel transistors 10, 11 and the length of the gate G of the third and fourth P-channel transistors 12, 13 are set at a rate of 2:1.

On the other hand, in N-channel regions 4N are formed first and second N-channel transistors 14, 15, and third and fourth N-channel transistors 16, 17, each consisting of gate region G, drain region D and common source region S. The length of the gate G of the first and second N-channel transistors 14, 15, and the length of the gate G of the third and fourth N-channel transistors 16, 17 are set at a rate of 2:1, same as at the P-channel side.

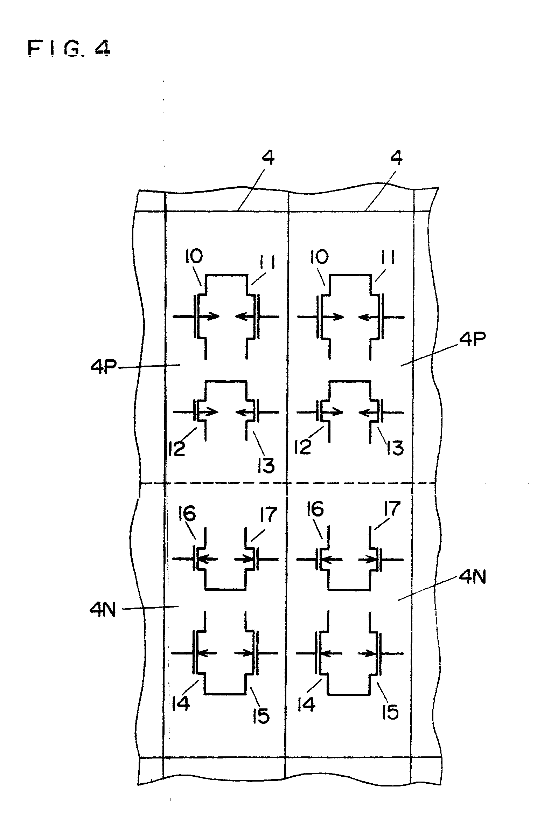

FIG. 4 is an equivalent circuit diagram of FIG. 3, and the same parts as in FIG. 3 are identified with same reference numerals, and the detailed explanation is omitted.

In this composition, transistors having driving capacity exactly as desired may be efficiently fabricated. For example, when the combined use of the first P-channel transistor 10 and first N-channel transistor 14 is regarded as a basic unit of driving capacity, its half driving capacity may be realized by using the third P-channel transistor 12 and the third N-channel transistor 61. Or to realize 1.5 times the basic unit of the driving capacity, the parallel connection of the first and third P-channel transisotrs 10, 12, and the parallel connection of the first and third N-channel transistors 14, 16 are combined.

Besides, when any combinations of the gate regions G, drain regions D and source regions S of the transistors 10 to 17 shown in FIGS. 3, 4 are mutually connected by wiring, logic gates such as NAND and OR may be composed, and by integrating them, a desired final circuit is realized.

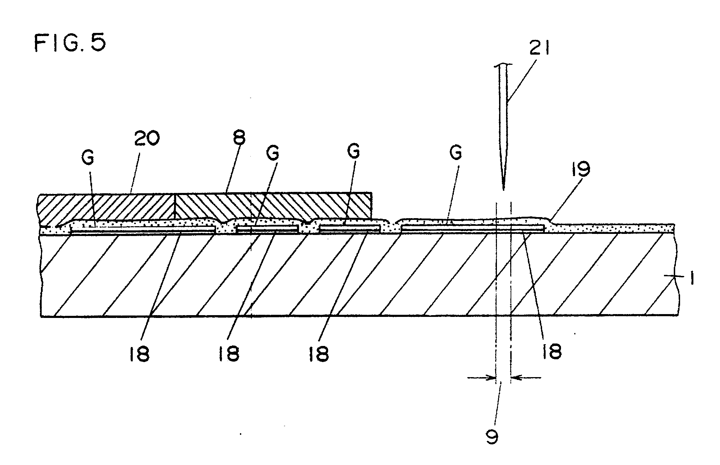

FIG. 5 is a sectional view showing a peripheral region of the chip shown in FIG. 3, and it corresponds to the X-X section of Fig. 3. A gate oxide film 18 is formed on the surface of the semiconductor substrate 1 which corresponds to the wafer, and gate regions G of transistors shown in Fig. 3 are formed thereon. The entire surface of the semiconductor substrate 1 including the gate regions G is covered with an insulation film 19, and the structure in this state is prepared as a master slice.

The transistor elements in FIG. 5 are positioned within the pad region 7 in FIG. 2. Therefore, these transistor elements are not used for composing the circuit, unlike the transistor elements in the internal circuit region 5 or input/output circuit region 6. Accordingly, on the insulation film 19 covering these transistor elements, a bonding pad 8 and a wiring 20 for mutually connecting the bonding pad 8 with transistor elements in the input/output circuit region 6 are formed in the same process.

After forming necessary wirings and protective film, the scribe lanes are cut off by a dicing saw 21, and the wafer 1 is divided into individual chips.

In the foregoing embodiments, a wafer 1 which the insulation film 19 is formed on the surface is prepared as a master slice, but it is also possible, needless to say, to use the master slice in the type shown in the specification and drawings disclosed in the patent application filed by the same applicant as the present applicant as
Serial No. 07/259,521
Application No. 88309787.5
that is, to use the wafer on which only the wiring of the uppermost layer of the multi-layer wiring is unformed, as the master slice.

## Claims

1. A semiconductor integrated circuit comprising:
a wafer made of a semiconductor substrate,
plural basic circuit elements formed in the entire surface portion of said wafer without leaving any space according to predetermined repetition patterns, and
wirings for mutually connecting only specific basic circuit elemnets cut of said plural basic circuit elements.

2. A semiconductor integrated circuit according to claim 1, wherein said basic circuit elements contain plural transistor elements differing in the driving capacity.

3. A semiconductor integrated circuit comprising:
a wafer made of a semiconductor substrate,
plural basic circuit elements formed in the entire surface portion of said wafer without leaving any space according to predetermined repetition patterns,
an internal circuit region composed of plural basic circuit elements in the number neither excessive nor insufficient for circuit scale of a desired final product,
an input/output circuit region composed of plural basic circuit elements adjacent to said internal circuit region,
a pad region for forming bonding pads, being disposed close to said input/output circuit region,
wirings for mutually connecting specified basic circuit elements in said internal circuit region and said input/output circuit region,
wirings for connecting specified basic circuit elements in said internal circuit region and said input/output circuit region, and said bonding pads formed in said pad region, and
scribe lanes disposed outside said pad region for dividing the wafer into individual chips.

4. A semiconductor integrated circuit according to claim 3, wherein said input, output circuit region contains the basic circuit elements in the number neither excessive nor insufficient for composing said input circuit or output circuit of the final circuit, and said pad region contains the basic circuit elements in the number neither excessive nor insufficient for forming necessary bonding pads of the final circuit.

5. A semiconductor integrated circuit according to claim 3, wherein an insulation film is formed on the entire surface of said wafer, and said bonding pads are formed on said insulation film in said pad region.

6. A semiconductor integrated circuit according to claim 3, wherein said basic circuit elements contain plural transistor elements differing in the dirving capacity.

7. A manufacutring method of a semiconductor integrated circuit comprising:
a step of forming plural basic circuit elements in the entire surface portion of a wafer made of a semiconductor substrate without leaving any space according to specified repetition patterns, and
a step of forming wirings for mutually connecting specified basic circuit elements of said plural basic circuit elements.

8. A manufacturing method of a semiconductor integrated circuit comprising:
a step of forming plural basic circuit elements in the entire surface portion of a wafer made of a semiconductor substrate without leaving any space according to specified repetition patterns,
a step of covering the entire surface of said wafer with an insulation film.

a step of defining, in said wafer, an internal circuit region composed of said basic circuit elements in the number neither excessive nor insufficient for the circuit scale of the desired final circuit, and input/output circuit region composed of plural basic circuit elements adjacent to said internal circuit region, a pad region composed of plural basic circuit elements adjacent to said input/output circuit region, and scribe lanes on the plural basic circuit elements adjacent to said pad region,
a step of forming, according to the specification of the final circuit, wirings for mutually connecting the specified basic circuit elements within said internal circuit region and input/output region, and wirings for mutually connecting the bonding pads on said insulation film in said pad region and the specified basic circuit elements in said internal circuit region or aid input/output region, and
a step of dividing said wafer along said scribe lanes.

FIG. 1

FIG. 2

## FIG. 3

EP 0 360 596 A1

FIG. 4

# FIG.5

FIG. 6

PRIOR ART

24

25  } 23

26

23

22

FIG. 7

PRIOR ART

25

27 } 26

28

29

23

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | PROCEEDINGS OF THE IEEE 1986 CUSTOM INTEGRATED CIRCUITS CONFERENCE, New York, 12th-15th May 1986, pages 572-575, IEEE, New York, US; Y. KURAMITSU et al.: "A 540k-transistor cmos variable track masterslice" * Page 573, paragraph 2.2: "Basic Cell Buffer Masterslice"; page 573, paragraph 3: "The Concept of PNN Basic Cell" * | 1-8 | H 01 L 27/118 |
| X | PATENT ABSTRACTS OF JAPAN, vol. 12, no. 99 (E-594), 31st March 1988; & JP-A-62 229 857 (TOSHIBA CORP.) 08-10-1987 * Abstract * | 1,3-5,7 ,8 | |
| Y | IDEM | 2,6 | |
| Y | PATENT ABSTRACTS OF JAPAN, vol. 12, no 465 (E-690), 7th December 1988; & JP-A-63 187 648 (FUJI XEROX CO. LTD) 03-08-1988 * Abstract * | 2,6 | TECHNICAL FIELDS SEARCHED (Int. Cl.5) |
| X | ELECTRONIC DESIGN, vol. 34, no. 4, 20th February 1986, pages 38,40, Hasbrouck Heights, US; D. BURSKY: "CMOS array doffs I/O cells, puts 36,000 gates on chip" * Whole article * | 1,3-5,7 ,8 | H 01 L 27/00 |

The present search report has been drawn up for all claims

| Place of search | Date of completion of the search | Examiner |
|---|---|---|
| THE HAGUE | 27-10-1989 | ZEISLER P.W. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

...................................................................................................
& : member of the same patent family, corresponding document

EPO FORM 1503 03.82 (P0401)